# EUROPEAN PATENT APPLICATION

(11) **EP 4 748 768 A1**
(43) Date of publication of application: **27.05.2026**
(21) Application number: 25213542.1
(22) Date of filing: 05.11.2025
(51) Int. Cl.: B66B 1/32

(54) **DEVICE AND METHOD FOR BRAKE CONTROL**

(30) Priority: 22.11.2024 CN 202411686206
(71) Applicant: Otis Elevator Company, Farmington, Connecticut 06032 (US)
(72) Inventor: Qiu, Heping, Shanghai, 200335 (CN); Tian, Hongliang, Shanghai, 200335 (CN); Cen, Baoxiang, Shanghai, 200335 (CN)
(74) Representative: Schmitt-Nilson Schraud Waibel Wohlfrom Patentanwälte Partnerschaft mbB

(57) **Abstract**

The present disclosure relates to an elevator technology, and in particular to a device and method for brake control. According to one aspect of the present disclosure, there is provided a device for brake control. The device comprises a first branch circuit and a second branch circuit connected in parallel with the first branch circuit. The first branch circuit and the second branch circuit comprise a first brake coil and a first switching element connected in series and a second brake coil and a second switching element connected in series, respectively. The device further comprises a third switching element connected between a power supply and the first branch circuit and the second branch circuit, which is configured to connect or disconnect the power supply with the first branch circuit and the second branch circuit in response to the state of an elevator safety chain. In the device, when the power supply is connected with the first branch circuit and the second branch circuit, the supply of power from the power supply to the first brake coil and the supply of power from the power supply to the second brake coil are controlled by the first switching element and the second switching element, respectively. In particular, control signals for the first switching element and the second switching element comprise a pulse width modulation signal.

## Description

The present disclosure relates to an elevator technology, and in particular to a device and method for brake control.

When an elevator car is in a static state (for example, when the car arrives at a designated landing), the traction motor loses power, and the coil of the brake device is also powered off at the same time. The magnetic force in the electromagnet core rapidly disappears, and the iron core is reset through the brake arm under the action of the brake spring, so that the brake shoes grip the brake wheel and the elevator stops working. When there is a current flowing into the brake coil, the electromagnet core is quickly magnetized and engages, driving the brake arm to completely disengage the brake shoes from the brake wheel, allowing the elevator car to operate.

To ensure that sufficient braking force can be provided, it is necessary to supply the brake coil with a relatively large current. Therefore, the brake coil is typically a high-power consumption element. This means a high-power power supply needs to be provided, which leads to issues such as more occupation of the installation space and increased costs.

According to one aspect of the present disclosure, there is provided a device for brake control. The device comprises a first branch circuit and a second branch circuit connected in parallel with the first branch circuit. The first branch circuit and the second branch circuit comprise a first brake coil and a first switching element connected in series and a second brake coil and a second switching element connected in series, respectively. The device further comprises a third switching element connected between a power supply and the first branch circuit and the second branch circuit, which is configured to connect or disconnect the power supply with the first branch circuit and the second branch circuit in response to the state of an elevator safety chain. In the device, when the power supply is connected with the first branch circuit and the second branch circuit, the supply of power from the power supply to the first brake coil and the supply of power from the power supply to the second brake coil are controlled by the first switching element and the second switching element, respectively. In particular, control signals for the first switching element and the second switching element comprise a pulse width modulation signal.

According to another aspect of the present disclosure, there is provided an elevator system, comprising the aforementioned device.

According to yet another aspect of the present disclosure, there is provided a method for brake control. In this method, the third switching element connected between the power supply and the first branch circuit and the second branch circuit is closed in response to an event of the elevator safety chain entering a closed state. The first branch circuit herein comprises the first brake coil and the first switching element connected in series, and the second branch circuit is in parallel connection with the first branch circuit and comprises the second brake coil and the second switching element connected in series. The method further comprises the step of controlling the supply of power from the power supply to the first brake coil and the second brake coil by the first switching element and the second switching element, respectively. In the above process of controlling the supply of power, control signals for the first switching element and the second switching element comprise a pulse width modulation signal.

The above and/or other aspects and advantages of the present disclosure will become clearer and easier to understand in conjunction with the following description in various aspects of the drawings. The same or similar units in the drawings are represented by the same reference numerals. Particular embodiments further may include at least one, or a plurality of, the following optional features, alone or in combination with each other.

The drawings include:
FIG. 1 shows an exemplary diagram of an elevator system.
FIG. 2 shows a schematic diagram of a device for brake control according to one embodiment of the present disclosure.
FIG. 3 shows a schematic diagram of brake control timing according to another embodiment of the present disclosure.
FIG. 4 shows a schematic diagram of brake control timing according to another embodiment of the present disclosure.
FIG. 5 shows a flow diagram of a method for brake control according to another embodiment of the present disclosure.
FIG. 6 shows a flow diagram of a method for brake control according to another embodiment of the present disclosure.
FIG. 7 shows a flow diagram of a method for brake control according to another embodiment of the present disclosure.

The present disclosure will be more fully described hereinafter with reference to the drawings of the exemplary embodiments of the present disclosure. However, the present disclosure may be implemented in different forms, and should not be construed as being limited only by the various embodiments provided herein. The various embodiments aim to make the present disclosure more comprehensive and complete, so that the protection scope of the present disclosure would be more fully conveyed to a person skilled in the art.

In this specification, the terms such as "comprise" and "include" indicate that in addition to the units and steps directly and explicitly stated in the specification and claims, the technical solution of the present disclosure also does not exclude the circumstances where there are other units and steps that are not directly or explicitly stated.

Unless specifically stated, the terms such as "first" and "second" do not indicate the sequence of the units in terms of time, space, size, and the like, but are merely used to distinguish various units.

It will be understood that the expressions such as "connecting" or "coupling" a component to another component include the circumstances where the component is directly connected to another component, and also include the circumstances where the component is connected to another component by an intermediate component.

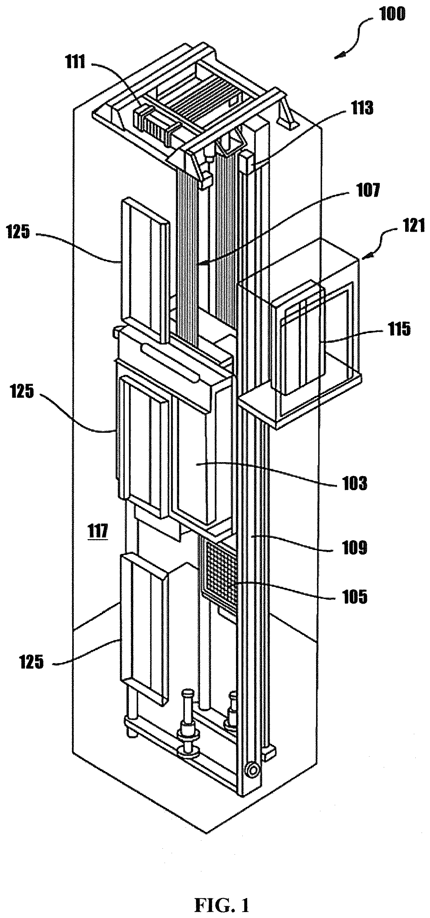

FIG. 1 shows an exemplary diagram of an elevator system. The elevator system 101 illustrated in FIG. 1 includes an elevator car 103, a counterweight 105, a tension member 107, a guide rail (or rail system) 109, a unit (or unit system) 111, a position reference system 113 and an electronic elevator controller (controller) 115. The elevator car 103 and the counterweight 105 may be coupled to each other by the tension member 107. The tension member 107 may include or be configured as, for example, a rope, a steel cable and/or a coated steel strip. The counterweight 105 is configured to balance the load of the elevator car 103, and is configured to facilitate moving the elevator car 103 within the elevator shaft (or hoistway) 117 and along the guide rail 109 relative to the counterweight 105 in the opposite direction and simultaneously.

The tension member 107 may be coupled to the unit 111 which may form part of the overhead structure of the elevator system 101. The unit 111 is configured to control movement between the elevator car 103 and the counterweight 105. The position reference system 113 may be installed on a fixed portion at the top of the elevator shaft 117, for example, on a support member or guide rail, and may be configured to provide position signals regarding the position of the elevator car 103 in the elevator shaft 117. In other embodiments, the position reference system 113 may be installed directly on a mobile component of the unit 111, or may be located in other positions and/or configurations known in the art. The position reference system 113 may be any device or mechanism known in the art for monitoring the position of the elevator car and/or the counterweight. As may be understood by a person skilled in the art, the position reference system 113, for example, includes but is not limited to encoders, sensors or other systems, and may perform various sensing such as velocity sensing, absolute position sensing and the like.

As shown therein, the controller 115 is located in a control room 121 of the elevator shaft 117, and is configured to control the operation of the elevator system 101 (and in particular, the elevator car 103). For example, the controller 115 may send drive signals to the unit 111 to control acceleration, deceleration, levelling, stopping etc. of the elevator car 103. The controller 115 may also be configured to receive position signals from the position reference system 113 or any other desirable position reference device. When moving up or down along the guide rail 109 within the elevator shaft 117, the elevator car 103 may stop at one or more landings 125 as controlled by the controller 115. In spite of being illustrated in the control room 121, a person skilled in the art will appreciate that the controller 115 may be located and/or configured in other places or positions within the elevator system 101. In one embodiment, the controller may be remotely located or positioned in the cloud.

The unit 111 may include a motor or a similar driving mechanism. According to the embodiments of the present disclosure, the unit 111 is configured to include an electrically driven motor. The power supply of the motor may be any power source, including a power grid, and the power source in combination with other components are supplied to the motor. The unit 111 may include traction sheaves which impart a force to the tension member 107 so as to move the elevator car 103 within the elevator shaft 117.

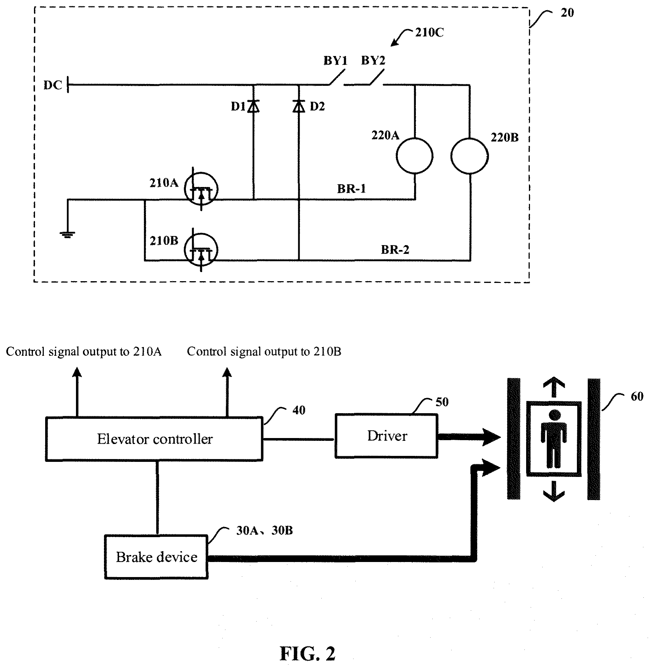

FIG. 2 shows a schematic diagram of a device for brake control according to one embodiment of the present disclosure. The device 20 illustrated in FIG. 2, as a component of the elevator system 1, comprises switching elements 210A, 210B and 210C, brake coils 220A and 220B respectively associated with brake devices 30A and 30B, and diodes D1 and D2.

Referring to FIG. 2, the switching element 210A and the brake coil 220A are connected in series and form a first branch circuit BR-1. On the other hand, the switching element 210B and the brake coil 220B are connected in series and form a second branch circuit BR-2. In addition, the first branch circuit BR-1 and the second branch circuit BR-2 are connected in parallel between the switching element 210C and the ground.

Exemplarily, the switching element 210A, 21B illustrated in FIG. 2 is an N-type or P-type metal-oxide-semiconductor field-effect transistor (MOSFET). It should be noted that other types of electronic switches may also serve as the switching element 210A, 210B, for example, including but not limited to an insulated gate bipolar transistor (IGBT) and a gate turn-off thyristor (GTO).

In some examples, the elevator system 1 further includes brake devices 30A, 30B, an elevator controller 40 (e.g., the controller 115 in FIG. 1), a driver 50 (e.g., the unit 111 in FIG. 1) and an elevator car 60. The connection or disconnection of the switching elements 210A and 210B is controlled by the elevator controller 40. Based on the control command of the elevator controller 40, the driver 50 controls movement between the car 60 and the counterweight, so that the car 60 can stop at the desired floor. In a normally operating elevator system, under the control of the elevator controller 40, the brake devices 30A and 30B lock into place to hold the car 60 stationary at its current position when the car 60 stops at a landing door, and the brake devices are in a released state in the process of the car 60 moving towards a landing door.

The switching element 210C is connected between a direct current (DC) power supply (e.g., a switch-mode power supply that provides a 48V direct current voltage) and the first branch circuit BR-1 and the second branch circuit BR-2. As illustrated in FIG. 2, the switching element 210C comprises safety relays BY1 and BY2 connected in series. The state of the switching element 210C or the safety relays BY1 and BY2 is controlled by an elevator safety chain. Exemplarily, when the elevator safety chain enters a closed state, the safety relays BY1 and BY2 will be triggered to enter a conducting state; on the other hand, when the elevator safety chain enters an open-circuit state, the safety relays BY1 and BY2 will be triggered to enter a disconnected state. In some embodiments, a trigger signal for safety relays is provided by a unit responsible for elevator safety control (e.g., a programmable electronic system in safety related applications for lifts (PESSAL)). It should be noted that the number of safety relays shown here is merely illustrative, and in the absence of mandatory regulation requirements, it is also feasible to use one safety relay as a switching element.

Further referring to FIG. 2, the anode of the diode D1 is connected to the switching element 210C or the safety relay BY1, and the cathode is connected to a common connection point between the brake coil 220A and the switching element 210A. Similarly, the anode of the diode D2 is connected to the switching element 210C or the safety relay BY1, and the cathode is connected to a common connection point between the brake coil 220B and the switching element 210B.

The operational principle of the device illustrated in FIG. 2 is described hereinafter.

When the elevator safety chain is in a closed state, the switching element 210C or the safety relays BY1, BY2 are also in or remain in a closed state, so that the DC power supply and the first branch circuit BR-1 and the second branch circuit BR-2 are in a conducting state. Then, if an enable signal (e.g., a high-level signal for an N-type MOSFET or a low-level signal for a P-type MOSFET) is applied at the control end of the switching element 210A or 210B (e.g., the gate electrode of the MOSFET), the switching element 210A or 210B will be in a conducting state, so that the DC power supply supplies power to the brake coil 220A or the brake coil 220B, thereby driving the brake arm to completely disengage the brake shoes from the brake wheel and allowing the elevator car to operate. On the other hand, if a disable signal (e.g., a low-level signal for an N-type MOSFET or a high-level signal for a P-type MOSFET) is applied to the control end of the switching element 210A or 210B, the switching element 210A or 210B will be in a blocked state, so that the DC power supply is prevented from supplying power to the brake coil 220A or the brake coil 220B, thereby causing the brake arm to reset and the brake shoes to grip the brake wheel. In this specification, various forms of enable signals and disable signals are collectively referred to as control signals for switching elements.

In some embodiments, to realize the supply of power from the DC power supply to the brake coil, the enable signal applied to the switching elements 210A and 210B does not need to always be a constant high-level signal or low-level signal. Specifically, when the brake shoes are already or almost completely disengaged from the brake wheel, reducing the current flowing into the brake coil from a higher level to a lower level can also ensure that the brake shoes are disengaged from the brake wheel. The aforementioned higher-level current and lower-level current are hereinafter referred to as a pick-up current and a holding current, respectively. By applying a pulse width modulation signal to the control ends of the switching element 210A and 210B as an enable signal, it is possible to reduce the current of the brake coil, thereby achieving the purpose of reducing power consumption. In this way, the desired magnitude of the holding current can be determined by adjusting the duty cycle of the pulse width modulation signal.

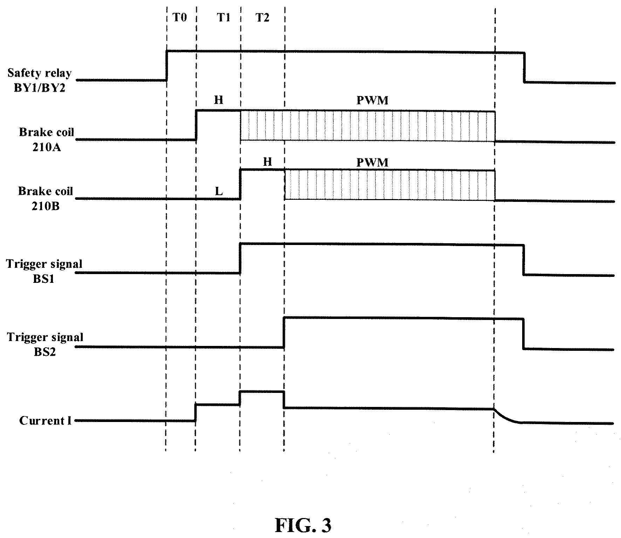

FIG. 3 shows a schematic diagram of brake control timing according to another embodiment of the present disclosure. In a further embodiment, the brake control logic can be implemented in a manner as illustrated in FIG. 3.

Referring to FIG. 3, after the safety relays BY1, BY2 begin to enter a closed state, a first phase with a duration of T1 is entered after a set duration of T0. In the first phase, under the control of the elevator controller 40, the control end of one of the switching elements 210A and 210B (take the switching element 210A as an example) is applied with a constant enable signal H (take a high-level signal as an example), so that a larger pick-up current flows into the brake coil 220A. Meanwhile, the control end of the other one of the switching elements 210A and 210B (the switching element 210B in the example) is applied with a constant disable signal L (take a low-level signal as an example), so that no current flows into the brake coil 220B.

After the first phase ends, a second phase with a duration of T2 is entered. In the second phase, under the control of the elevator controller 40, the control end of the switching element 210A starts to be applied with a pulse width modulation (PWM) signal, so that a smaller holding current flows into the brake coil 220A. Meanwhile, the control end of the switching element 210B is applied with a constant enable signal H so that a larger pick-up current flows into the brake coil 220B.

In the example illustrated by FIG. 3, the durations T1 and T2 can be set according to application requirements. For example, they may be set as the time required for the brake shoes and brake wheel of a brake to achieve complete disengagement at a specific pick-up current.

After the second phase ends, a third phase is entered. In the third phase, under the control of the elevator controller 40, on the one hand, the control end of the switching element 210A continues to be applied with the pulse width modulation (PWM) signal; on the other hand, the control end of the switching element 210B starts to be applied with the pulse width modulation (PWM) signal so that a smaller holding current flows into the brake coil 220B.

When it is necessary to perform braking operation again to keep the elevator car stationary, the third phase ends. Then, under the control of the elevator controller 40, the control ends of the switching elements 210A and 210B are applied with a constant disable signal L. As illustrated in FIG. 3, in response to the trigger signals BS1 and BS2 (the signals may come from the brake devices) indicating that the brake devices 30A and 30B have entered a brake state, the safety relays BY1 and BY2 transition from a closed state to a disconnected state.

Further referring to FIG. 3, it shows the variation of the current I flowing into the brake coils 220A and 220B over time. In the first phase, the current I only includes the component of the pick-up current flowing into the brake coil 220A. Then, the second phase is entered. The current I is increased due to the inclusion of the component of the holding current for the brake coil 220A and the component of the pick-up current for the brake coil 220B. Next, the third phase is entered. The current I is decreased due to the inclusion of the holding current for the brake coil 220A and the brake coil 220B. Compared with the method of simultaneously activating the brake devices 30A and 30B (i.e., the pick-up current flows into the brake coils 220A and 220B at the same time), the method of sequentially activating the brake devices 30A and 30B as illustrated in FIG. 3 can effectively reduce the peak value of the current I, and therefore can reduce the specifications of the components used.

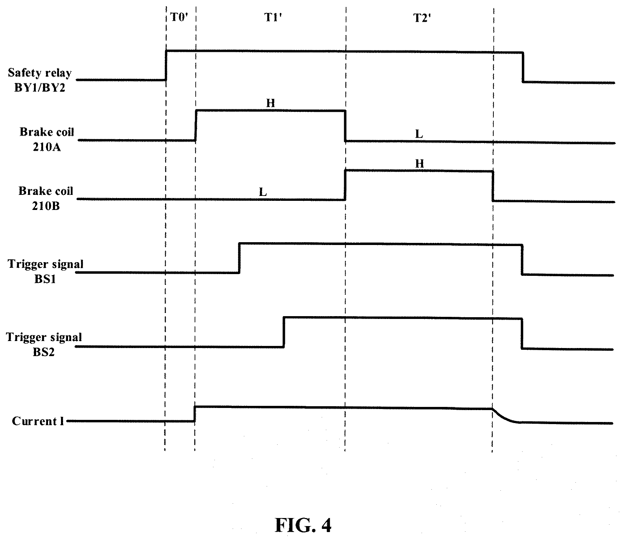

FIG. 4 shows a schematic diagram of brake control timing according to another embodiment of the present disclosure. In a further embodiment, the brake control logic can be implemented in a manner as illustrated in FIG. 4.

Referring to FIG. 4, after the safety relays BY1, BY2 are energized, a first phase with a duration of T1' is entered after a set duration of T0'. In the first phase, under the control of the elevator controller 40, the control end of one of the switching elements 210A and 210B (take the switching element 210A as an example) is applied with a constant enable signal H (take a high-level signal as an example), so that a larger pick-up current flows into the brake coil 220A. Meanwhile, the control end of the other one of the switching elements 210A and 210B (the switching element 210B in the example) is applied with a constant disable signal L (take a low-level signal as an example), so that no current flows into the brake coil 220B. In this phase, the functionality of the brake device 30A can be tested separately.

After the first phase ends, a second phase with a duration of T2' is entered. In the second phase, under the control of the elevator controller 40, the control end of the switching element 210A is applied with a disable signal L, while the control end of the switching element 210B is applied with a constant enable signal H. In this phase, the functionality of the brake device 30B can be tested separately.

Further referring to FIG. 2, in the illustrated embodiment, the diodes D1 and D2 serve the functions of a freewheeling element and a protection element. Take the switching element 210A as an example. During the period of the control end being applied with a pulse width modulation signal, when the switching element 210A is in a disconnected state, the diode D1, the safety relays BY1, BY2 and the brake coil 220A form a current branch circuit, so that there is still a current flowing into the brake coil 220A. On the other hand, the switching element 210A typically switches between a conducting state and a disconnected state at an extremely high frequency, which will generate a relatively large back electromotive force in the brake coil 220A. If there is lack of proper protection measures, the back electromotive force may damage the components (e.g., transistors, MOSFET or other semiconductor components) in the device 20. The diode D1, which has the property of unidirectional conduction, provides a low-impedance path to guide the back electromotive force to a safe direction, thereby achieving the purpose of protecting the circuit.

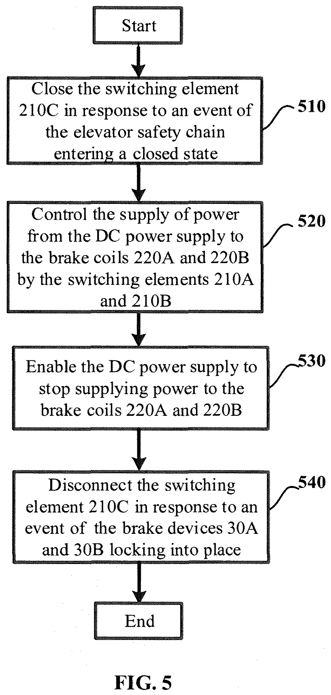

FIG. 5 shows a flow diagram of a method for brake control according to another embodiment of the present disclosure. Exemplarily, it is assumed that the method illustrated in FIG. 5 is implemented by using the device illustrated in FIG. 2.

The process flow illustrated in FIG. 5 starts at step 510. In this step, the switching element 210C is closed in response to an event of the elevator safety chain entering a closed state.

Then proceed to step 520. In this step, the elevator controller 40 controls the supply of power from the DC power supply to the brake coils 220A and 220B via the switching elements 210A and 210B respectively. During the control of the switching elements 210A and 210B, the control signals include a pulse width modulation signal.

Next, in step 530, the elevator controller 40 enables the DC power supply to stop supplying power to the brake coils 220A and 220B by controlling the switching elements 210A and 210B, in response to an event of the elevator safety chain entering an open-circuit state.

After performing step 530, the process illustrated in FIG. 5 proceeds to step 540. In this step, the switching element 210C is disconnected in response to an event of the brake devices 30A and 30B locking into place, for example, by using a unit responsible for elevator safety control to provide a trigger signal to the safety relay or other means.

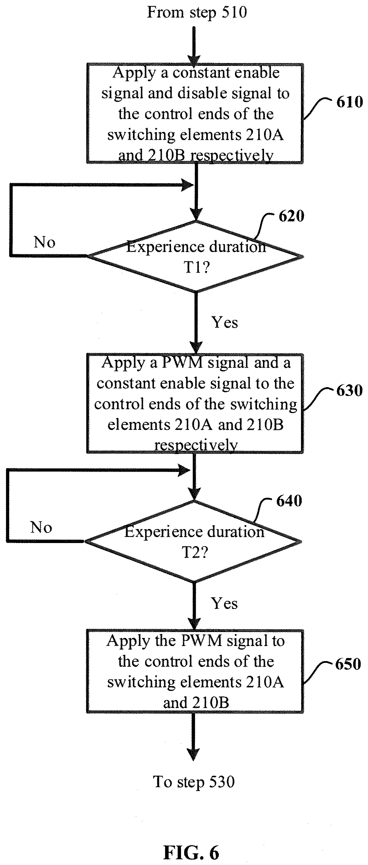

FIG. 6 shows a flow diagram of a method for brake control according to another embodiment of the present disclosure. The method illustrated in FIG. 6 can be used for performing the step 520 in FIG. 5.

Referring to FIG. 6, in step 610, under the control of the elevator controller 40, the control end of the switching element 210A is applied with a constant enable signal H1, while the control end of the switching element 210B is applied with a constant disable signal L.

Next, in step 620, the elevator controller 40 determines whether the application of the enable signal H1 has experienced the duration T1. If it has experienced the duration T1, then proceed to step 540; otherwise, continue to wait.

In step 630, under the control of the elevator controller 40, the control end of the switching element 210A is applied with a pulse width modulation (PWM) signal, while the control end of the switching element 210B is applied with a constant enable signal H2.

Then proceed to step 640. The elevator controller 40 determines whether the application of the enable signal H2 has experienced the duration T2. If it has experienced T2, then proceed to step 650; otherwise, continue to wait.

In step 650, under the control of the elevator controller 40, the control end of the switching element 210A continues to be applied with the pulse width modulation (PWM) signal, and the control end of the switching element 210B starts to be applied with the pulse width modulation (PWM) signal.

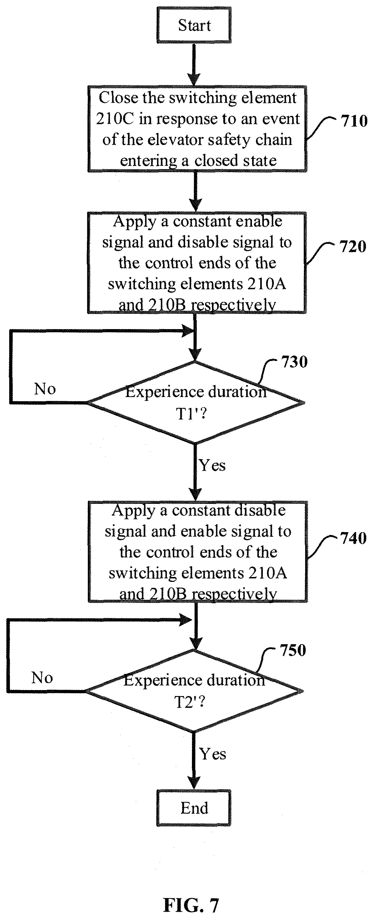

FIG. 7 shows a flow diagram of a method for brake control according to another embodiment of the present disclosure. Exemplarily, it is assumed that the method illustrated in FIG. 7 is implemented by using the device illustrated in FIG. 2.

The process flow illustrated in FIG. 7 starts at step 710. In this step, the switching element 210C is closed in response to an event of the elevator safety chain entering a closed state.

Then proceed to step 720. In this step, under the control of the elevator controller 40, the control end of the switching element 210A is applied with a constant enable signal H1, while the control end of the switching element 210B is applied with a constant disable signal L.

Next, in step 730, the elevator controller 40 determines whether the test on the brake device 30A is completed. If it is completed, then proceed to step 740; otherwise, continue to wait.

In step 740, under the control of the elevator controller 40, the control end of the switching element 210A is applied with a disable signal L, while the control end of the switching element 210B is applied with a constant enable signal H2.

Then proceed to step 750. The elevator controller 40 determines whether the test on the brake device 30B is completed. If it is completed, then the process ends; otherwise, continue to wait.

A person skilled in the art will appreciate that, various illustrative logic blocks, modules, circuits and algorithmic steps described herein may be implemented as electronic hardware, computer software or a combination of both.

To demonstrate interchangeability between hardware and software, various illustrative components, blocks, modules, circuits and steps have been described above in general terms based on their functionality. Such functionality is implemented in the form of hardware or software, depending on particular applications and design constraints imposed on the overall system. A person skilled in the art may implement the described functionality in varying ways for particular applications, but such implementation decisions should not be construed to result in a departure from the scope of the present disclosure.

While only some embodiments of the present disclosure are described, it should be understood by a person skilled in the art that the present disclosure can be implemented in various other forms without departing from its main purpose and scope. Therefore, the examples and embodiments provided are intended to be illustrative rather than restrictive, and the present disclosure may encompass various modifications and substitutions without departing from the spirit and scope of the present disclosure as defined in the appended claims.

The embodiments and examples are provided herein to best explain the embodiments of the technology and its particular application, so that a person skilled in the art can exploit and implement the present disclosure. However, a person skilled in the art will appreciate that the foregoing description and examples are provided for the purpose of illustration and exemplification only. The description provided is not intended to cover every aspect of the present disclosure or to limit the present disclosure to the precise form disclosed.

## Claims

1. A device for brake control, comprising:
a first branch circuit, comprising a first brake coil and a first switching element connected in series;
a second branch circuit connected in parallel with the first branch circuit, comprising a second brake coil and a second switching element connected in series; and
a third switching element connected between a power supply and the first branch circuit and the second branch circuit, the third switching element being configured to connect or disconnect the power supply with the first branch circuit and the second branch circuit in response to a state of an elevator safety chain,
wherein when the power supply is connected with the first branch circuit and the second branch circuit, the supply of power from the power supply to the first brake coil and the supply of power from the power supply to the second brake coil are controlled by the first switching element and the second switching element, respectively,
wherein control signals for the first switching element and the second switching element comprise a pulse width modulation signal.

2. The device according to claim 1, further comprising:
a first diode, wherein an anode of the first diode is connected to the third switching element, and a cathode of the first diode is connected to a common connection point between the first brake coil and the first switching element; and
a second diode, wherein an anode of the second diode is connected to the third switching element, and a cathode of the second diode is connected to a common connection point between the second brake coil and the second switching element.

3. The device according to claim 1 or 2, wherein the first switching element and the second switching element are one of the following: a metal-oxide-semiconductor field-effect transistor, an insulated gate bipolar transistor and a gate turn-off thyristor, and the third switching element is a safety relay.

4. The device according to any of claim 1 to 3, wherein the supply of power is controlled by :
after the power supply is connected with the first branch circuit and the second branch circuit, applying a constant first enable signal to a control end of the first switching element;
after the application of the first enable signal experiences a first duration, on the hand, applying the pulse width modulation signal to the control end of the first switching element, and on the other hand, applying a constant second enable signal to a control end of the second switching element; and
after the application of the second enable signal experiences a second duration, applying the pulse width modulation signal to the control end of the second switching element.

5. The device according to claim 4, wherein the first duration and the second duration are set to ensure brake shoes and a brake wheel of a brake achieve complete disengagement.

6. The device according to any of claims 1 to 5, wherein the supply of power is controlled by:
after the power supply is connected with the first branch circuit and the second branch circuit, enabling the power supply to only supply power to one of the first brake coil and the second brake coil, by applying control signals with opposite polarity to control ends of the first switching element and the second switching element respectively.

7. The device according to any of claims 1 to 6, wherein the control signals come from an elevator controller.

8. An elevator system, comprising the device according to any one of claims 1 to 7.

9. A method for brake control, comprising the following steps:
A. closing a third switching element connected between a power supply and a first branch circuit and a second branch circuit in response to an event of an elevator safety chain entering a closed state, wherein the first branch circuit comprises a brake coil and a first switching element connected in series, and the second branch circuit is connected in parallel with the first branch circuit and comprises a second brake coil and a second switching element connected in series; and
B. controlling the supply of power from the power supply to the first brake coil and the second brake coil by the first switching element and the second switching element respectively, wherein control signals for the first switching element and the second switching element comprise a pulse width modulation signal.

10. The method according to claim 9, further comprising:
C. enabling the power supply to stop supplying power to the first brake coil and the second brake coil by controlling the first switching element and the second switching element, in response to an event of the elevator safety chain entering an open-circuit state; and
D. disconnecting the third switching element in response to an event of a brake device locking into place.

11. The method according to claim 9 or 10, wherein the step B comprises:
applying a constant first enable signal to a control end of the first switching element;
after the application of the first enable signal experiences a first duration, on the one hand, applying the pulse width modulation signal to the control end of the first switching element, and on the other hand, applying a constant second enable signal to a control end of the second switching element; and
after the application of the second enable signal experiences a second duration, applying the pulse width modulation signal to the control end of the second switching element.

12. The method according to claim 11, wherein the first duration and the second duration are set to ensure brake shoes and brake wheel of a brake achieve complete disengagement.

13. The method according to any of claims 9 to 12, further comprising:
E. enabling the power supply to only supply power to one of the first brake coil and the second brake coil, by applying control signals with opposite polarity to control ends of the first switching element and the second switching element respectively.
